(19)

Europäisches
Patentamt
European
Patent Office
Office européen
des brevets

(11) **EP 3 503 214 A1**

(12) **EUROPEAN PATENT APPLICATION**

(43) Date of publication:
**26.06.2019 Bulletin 2019/26**

(51) Int Cl.:
*H01L 31/048* [(2014.01)]    *H01L 31/0216* [(2014.01)]

(21) Application number: **17210122.2**

(22) Date of filing: **22.12.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **Merck Patent GmbH**
**64293 Darmstadt (DE)**

(72) Inventor: **The designation of the inventor has not yet been filed**

(54) **SOLAR CELLS**

(57)    The invention relates to colored solar cells comprising effect pigments consisting of a transparent or semi-transparent flake-form substrate coated with one or more layers of transparent or semi-transparent materials.

**New Fig. 1**

EP 3 503 214 A1

**Description**

The invention relates to colored solar cells comprising effect pigments consisting of a transparent or semi-transparent flake-form substrate coated with one or more layers of transparent or semi-transparent materials.

Solar cells showed a great success over the last years and will surpass the global annual grid connected installation of 100 GW in 2017 with the majority being installed in utility scale. The basic function of all solar cells is the same: A photoactive material absorbs light and generates an excited electron-hole pair. This electron-hole pair is separated within the solar cell by areas with different mobilities for electrons and holes - a so called p-n junction. As different kinds of light absorbing materials can be used, the solar industry knows several different kinds of solar cell technologies:

1) Crystalline silicon solar cells (mono crystalline c-Si and multi crystalline mc-Si)
2) Cadmium-Telluride Solar cells (CdTe)
3) Copper-Indium-Gallium-Diselenide (CIGS/CIS)
4) Amorphous silicon solar cells (a-Si)
5) III/V solar cells like Gallium-Arsenide (GaAs) solar cells or multi-junction solar cells consisting of stacks of group III and group V elements like Germanium/Indium-(Aluminium)-Gallium-Arsenide or phosphide (In(Al)GaAs/P)
6) Dye sensitized solar cells (DSSC)
7) Organic solar cells (OSC)
8) Perovskite solar cells (PSC)
9) Quantum dot solar cells (QSC)
10) Other II/VI solar cells consisting of elements of group II and group VI like Zinkselenide (ZnSe) or Ironsulfide (FeS)

However, to use more surfaces of buildings and other surfaces on objects (e.g. cars) would increase the overall surface areas you can use for solar energy production. For this new techniques and approaches to make solar cells with appealing colors and to increase efficiencies under different absorption angles are of mayor interest for the solar energy business.

The use of pigments in solar cells for cooling is described in JP 5648906 B2. The pigments are used to reflect a part of IR solar radiation to reduce the operating temperature of the solar cells.

Today the options and technologies to get colored solar cells are limited:

(1) Use the limited color options of Si-Layers and other technologies;
(2) Color by change of the anti-reflective coating;
(3) Use of colored glass;
(4) Use of reflective interlayers.

Most technologies and materials are not giving nice colors and the coloration goes along with significant loss in efficiency of the solar cell or they are expensive due to high production costs (multi-layer technologies). Efficiency loss in the range of 15 - 40% are possible.

The object of the invention is to offer a high efficient material and method to color state of the art solar cells with great flexibility and achieving huge range of different colors with negligible loss in solar cell efficiency, and high level of long term stability.

Surprisingly it has been found that effect pigments according to the invention are ideal to give sufficient color when printed on glass or Si or used in EVA films without reducing the overall solar cell efficiency significantly. Long term test showed high level of stability. A climate chamber damp heat 1000 test (as described in: http://sinovoltaics.com/learning-center/testing/damp-heat-test/) showed no impact on the long-term stability of the manufactured single cell solar modules with a pigment layer in any binder directly printed on top of the solar cell. As the direct contact between the pigment containing layer and the solar cell is the most demanding location in the setup of a solar module, no negative effect in any position of the solar module stack can be assumed.

The effect pigments are reflecting a part of the visible sun light, but they let pass the light needed to create energy. These pigments can even be orientated in a way so that you can module the angle of best efficiency and can play with color and efficiency. The ability to apply effect pigments easily to state of the art solar cells makes the application even more efficient.

The invention thus relates to the use of flake-form effect pigments in solar cells. Especially, the invention relates to solar cells comprising effect pigments consisting of a transparent or semi-transparent flake-form substrate coated with one or more layers of transparent or semi-transparent materials.

A main advantage of the invention is the possibility to seamlessly integrate solar cells into any surface by changing the appearance to a neutral look which people are used to. The coloration of the solar cells or modules is possible over a variety of colors and not limited to a rigid substrate like glass or a single solar cell technology. Additionally, any complex solutions like another layer in the lamination stack is not necessarily needed.

Additionally, the costs of solar power are not increased in a significant way, because the efficiency of the solar cells is not impacted too heavily in contrast to currently available technologies, which have the great drawback of an impact on the solar cell performance, where under real life conditions the efficiency of solar cells drops below 10% from an initial performance of >15%.

Surprisingly, effect pigments show the possibility to homogeneously color solar cells with a minor impact on cell efficiency if the concentration of the pigment is chosen accordingly. Surprisingly, it has been found that especially conventional effect pigments such as pearlescent pigments, interference pigments and/or multi-layer pigments show the effects. As the working principle of these pigments is based on a selected reflection of a specific wavelength area, the color effect can be tuned selectively and the resulting efficiency can be directly correlated to reflected portion of light. In general, a desired color-effect can already be obtained at low reflections of a specific wavelength. The performance can even be increased in dedicated wavelength of 700 to 1100 nm detected by some flakes - being important for the quantum efficiency. Long term stability of whole system was tested positively.

As the pigments can locally and flexibly be applied on any surface all different applications can be served:

1) Pigment coating can be applied on the exterior of a finished solar cell or module, on the protective substrate covering the module (glass or plastic), on or in any lamination material like EVA, TPU or silicone or directly on the photoactive material/solar cells.

2) Pigment layer can be applied by several printing methods such as gravure printing, flexo printing, offset printing, tampon printing, preferably screen printing, (micro) spray coating, dip coating, slot-die coating, doctor blade/knife coating, dispensing, laser-assisted transfer, curtain coating, film transfer coating, aerosol jetting, powder coating, inkjet printing, brushing or similar methods..

3) Applications in any typically pigmented surface like buildings, communication and transportation objects such as for example cars, trains, trucks, trailers, manual devices, ships, price tags, plastics, wearable items and home appliances or similar.

4) The invention can be applied to any kind of solar cell technologies including amorphous, mono- and multi crystalline silicon solar cells, CIGS, CdTe, III/V solar cells, II/VI solar cells, Perovskite solar cells, organic solar cells and dye sensitized solar cells as well as modules made out of single cells. Crystalline solar cells include cell structures like Al-BSF, PERC, PERL, PERT, HIT, IBC, bifacial or any other cell type based on crystalline silicon substrates.

5) The invention can be used to seamlessly integrate solar cells into buildings (façade and roof), portable and installed devices, automotive vehicles (cars, motorcycles, scooters, trucks and similar) or other kinds of solar installations where the typical technical look of solar cells would make a change to the typical appearance people are used to and long-term stability is essential.

The pigment layers render appearance of solar cells' front surfaces to different colors, as e. g. red, violet, green etc. Pigment layers may comprise different layer thicknesses as well as different concentrations of pigment particles.

The invention provides the possibility to seamlessly integrate solar cells into any surface by changing the appearance to a neutral look which people are used to. Advantageously, the present invention enables the incorporation of solar cells into many kinds of surfaces such as buildings, cars, hand hold devices or any other highly visible surface that needs a seamless integration of solar cells without changing the optical appearance.

Advantageously, pigmented coatings of the invention may also be used as anti-reflective coatings.

The effect pigments used according to the invention are preferably transparent or at least semi-transparent. The effect pigments useful for the invention exhibit preferably a green color. However, other colors like blue, grey, white, violet, red, orange, black are also suitable. Other colors or their mixture to produce specific colours and shades can be used. The effect pigments can also produce metallic effects, such as but not limited to: silver, platinum, gold, copper and variety of other metals. It is also possible to create a printed images / pictures using a mixture of different colors.

Besides their specific color, the layer of effect pigments shows a high level (at least 30%, preferably >80%) of transparency for radiation relevant for the specific solar cell, preferably for radiation in the range of 260 to 1200 nm and a reflection level of about 5 to 40 % preferable below 10%. Internal and external quantum efficiency is preferably of > 0,8% in the area of 260 to 1200 nm wavelength. The quantum efficiency describes the amount of photons used for electricity generation. The external quantum efficiency (EQE) describes the wavelength selective relation of the amount of total photons shining on the solar cell in correlation to the amount of photons absorbed by the solar cell and efficiently converted into electricity. The internal quantum efficiency (IQE) describes the relation of the amount of photons which arrive in the solar cell and are converted to electricity. In the case of the invention the difference between the internal and external quantum efficiency can be described in a way:

$$EQE = IQE - \text{reflected photons by the pigment layer.}$$

The high level of the both the IQE and EQE thus shows the limited impact of the pigments on the solar cell performance.

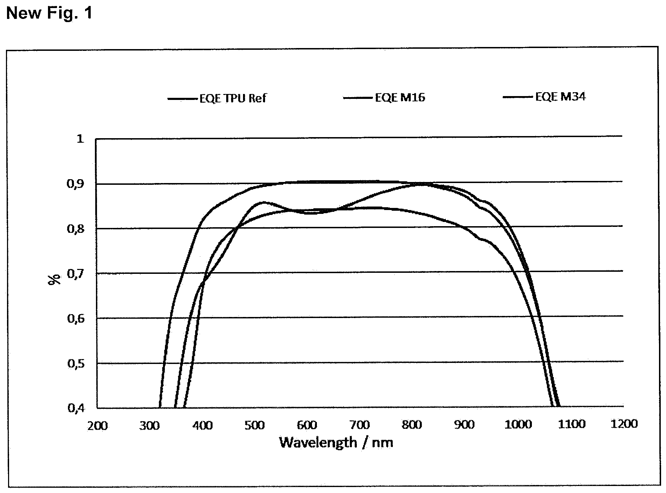

As shown in Fig. 1, the reference with a TPU based encapsulant shows (yellow graph) a typical EQE of 90% over a wide wavelength, a pigment mixture leading to a white/grey appearance of the solar cell shows a drop by ~7% (brown curve) and a green pigment based on coated glass flakes shows an averaged drop below 5% and even an increase of the quantum efficiency in the IR region.

The effect pigments employed in accordance with the invention preferably have a flake-form substrate which comprises at least one coating comprising a metal oxide, metal oxide hydrate or mixtures thereof. Preferably, the effect pigments consist of transparent or semi-transparent, colorless, flake-form substrates, which have been coated with one or more layers of transparent or semi-transparent, colorless materials. Preference is given to the use of pearlescent pigments, interference pigments, and/or multi-layer pigments. Long term stability of the effect pigments can be approved with using organic coatings or inorganic coatings as last layers of the pigments like described in WO 2011/095326 A1 and below.

Suitable substrates for the effect pigments are, for example, all known coated or uncoated, flake-form substrates, preferably transparent or semi-transparent, preferably colorless flakes. Suitable are, for example, phyllosilicates, in particular synthetic or natural mica, glass flakes, $SiO_2$ flakes, $Al_2O_3$ flakes, $TiO_2$ flakes, liquid crystal polymers (LCPs), holographic pigments, BiOCl flakes or mixtures of the said flakes.

The glass flakes can consist of all glass types known to the person skilled in the art, for example of A glass, E glass, C glass, ECR glass, recycled glass, window glass, borosilicate glass, Duran® glass, labware glass or optical glass. The refractive index of the glass flakes is preferably 1.45-1.80, in particular 1.50-1.70. Especially preferred glass flakes consist of A glass, C glass, E glass, ECR glass, quartz glass and borosilicate glass.

Preference is given to coated or uncoated flakes of synthetic or natural mica, $SiO_2$ flakes, $Al_2O_3$ flakes, and glass flakes, in particular glass flakes of C glass, ECR glass or calcium aluminium borosilicate. Especially, effect pigments based on calcium aluminum borosilicate glass are preferably used.

The substrates generally have a thickness of between 0.01 and 5 $\mu$m, in particular between 0.05 and 4.5 $\mu$m and particularly preferably from 0.1 to 1 $\mu$m. The length or width dimension is usually from 1 to 500 $\mu$m, preferably from 1 to 200 $\mu$m and in particular from 5 to 125 $\mu$m. They generally have an aspect ratio (ratio of mean diameter to mean particle thickness) of from 2:1 to 25,000:1, preferably from 3:1 to 1000:1 and in particular from 6:1 to 250:1. The said dimensions for the flake-form substrates in principle also apply to the coated effect pigments used in accordance with the invention, since the additional coatings are generally in the region of only a few hundred nanometres and thus do not significantly influence the thickness or length or width (particle size) of the pigments.

The particle size and the particle size distribution of the effect pigments and their substrates can be determined by various methods which usual in the art. However, use is preferably of the laser diffraction method in a standard process by means of a Malvern Mastersizer 2000, Beckman Coulter, Microtrac, etc. In addition, other technologies such as SEM (scanning electron microscope) images can be used.

In a preferred embodiment, the substrate is coated with one or more transparent or semitransparent layers comprising metal oxides, metal oxide hydrates, metal hydroxides, metal suboxides, metal fluorides, metal nitrides, metal oxynitrides or mixtures of these materials. Preferably, the substrate is partially or totally encased with these layers.

Furthermore, multilayered structures comprising high- and low-refractive-index layers may also be present, where high- and low-refractive-index layers preferably alternate. Particular preference is given to layer packages comprising a high-refractive-index layer (refractive index $\geq 2.0$) and a low-refractive-index layer (refractive index $< 1.8$), where one or more of these layer packages may have been applied to the substrate. The sequence of the high- and low-refractive-index layers can be matched to the substrate here in order to include the substrate in the multilayered structure.

Particular preference is given to metal oxides, metal oxide hydrates or mixtures thereof, preferably of Ti, Sn, Si, Al, Zr and Zn, especially of Ti, Sn and Si. Oxides and/or oxide hydrates may be present in a single layer or in separate layers. Particularly, titanium dioxide, in the rutile or anatase modification, preferably in the rutile modification is used. For conversion of titanium dioxide into the rutile modification, a tin dioxide layer is preferably applied beneath a titanium dioxide layer. Preferred multi-layer coatings comprise alternating high- and low-refractive-index layers, preferably such as $TiO_2$ - $SiO_2$ - $TiO_2$.

The layers of metal oxides, hydroxide and/or oxide hydrates are preferably applied by known wet-chemical methods, where the wet-chemical coating methods developed for the preparation of effect pigments, which result in enveloping of the substrate, can be used. After the wet-chemical application, the coated products are subsequently separated off, washed, dried and preferably calcined.

The thickness of the individual layers thereof is usually 10 to 1000 nm, preferably 15 to 800 nm, in particular 20 to 600 nm, especially 20 to 200 nm.

In order to increase the light, temperature, water and weather stability, the effect pigment may be subjected to post-coating or post-treatment.

Suitable post-coating or post-treatment methods are, for example, the methods described in DE 22 15 191, DE-A 31 51 354, DE-A 32 35 017 or DE-A 33 34 598, EP 0090259, EP 0 634 459, WO 99/57204, WO 96/32446, WO 99/57204, U.S. 5,759,255, U.S. 5,571,851, WO 01/92425, WO 2011/095326 or other methods known to the skilled man.

Effect pigments which can be used for the invention are, for example, the commercially available interference pigments or pearlescent pigments offered under the trade names Iriodin®, Pyrisma®, Xirallic®, Miraval®, Colorstream®, RonaStar®, Biflair®, and Lumina Royal®. Other commercially available effect pigments may also be used. Especially, Colorstream®, Xirallic®, Miraval®, and Ronastar® pigments may be used.

For application in a solar cell, the effect pigments are incorporated into an application medium, preferably a transparent coating formulation and subsequently applied to the solar cell.

The application medium may be selected from for example water-based varnishes, solvent-based varnishes, UV curable varnishes, and E-beam curable varnishes.

The application medium of the invention may also comprise a mixture of different effect pigments, since in many cases the use of at least two different effect pigments makes it possible to obtain special effects. In that case the effect pigments can be mixed in any proportion, although the overall content of all effect pigments in the application medium should not exceed 60% by weight.
are

The concentration of the effect pigment or mixture of effect pigments is preferably in the range of 1-25 % by weight based on the total weight of the application medium. Preferably, the amount of effect pigment is in the range of 2 - 15 % by weight, particularly in the range of 2 - 12, especially 3 - 8 % by weight.

A typical medium is generally prepared by mixing one or more effect pigments with a selected commercially available ready-to-use varnish. A specific varnish can also be made to meet any strict demands.

A typical varnish contains at least: one or more binders and a solvent or a mixture of solvents. In addition the varnish can also contain other additives: anti-foaming agents, anti-sagging agents, dispersing agents, leveling agents, scratch resistance additives, substrate wetting agents, coupling agents, corrosion inhibitors, rheology modifiers, fire redundants, stabilizers, catalysts, odor masking agents, etc

A typical varnish contains pigment, binder, and solvent, and also can contain other additives: anti-foaming agent anti-sagging agents, dispersing agents, leveling agents, scratch resistance, substrate wetting agents, coupling agents, corrosion inhibitors, rheology modifiers, fire redundant, stabilizers, catalysts, odor masking agents, etc

The application medium is generally prepared by initially introducing one or more effect pigments and mixing them homogeneously with binder, solvent, and any additives.

Binders which can be used are the binders or binder systems usually employed for printing processes, for example aqueous or solvent-containing binders based on nitrocellulose, based on polyamide, based on acrylate, based on polyvinylbutyral, based on PVC, based on PUR or suitable mixtures thereof. Two component systems can be used. For the success of the invention, it is preferred that the corresponding binders or binder systems cure in a transparent and colorless manner in order not to hinder the effects of the invention.

Preferably, the binders are transparent for visible light, provide good adhesion to solar cell or the lamination or the scratch resistant / protection layer (depend when applied), good stability to the environment, and if used not as the final layer provide good wettability and adhesion to the subsequent layer.

Besides water, it is also possible to employ organic solvents, for example branched or unbranched alcohols, aromatic compounds or alkyl esters, such as ethanol, 1-methoxypropanol, 1-ethoxy-2-propanol, ethyl acetate, butyl acetate, toluene or mixtures comprising these. The respective colored coating formulation may, however, also have a low solvent content or be entirely free from solvents if radiation-curing binder systems, such as, for example, UV-curing binder systems, are used.

Besides the binder or binder system and where appropriate the solvent or solvents, the coating vehicle may, in addition to the respective effect pigments, also comprise various assistants and/or additives.

Suitable additives are UV stabilisers, inhibitors, flameproofing agents, lubricants, dispersants, re-dispersants, antifoams, flow-control agents, film formers, adhesion promoters, drying accelerators, drying retardants, photoinitiators, etc. The respective coating vehicle preferably comprises all necessary assistants in liquid form in order that the effects of the invention are not weakened or otherwise impaired by additional solids. For this reason, it is preferred that neither (soluble) dyes nor other coloring pigments or solid fillers apart from the effect pigments necessary in accordance with the invention are present in the finished colored coating inks.

The pigmented coating formulation can subsequently be applied by various methods, for example by screen printing, flexo printing, gravure printing, offset printing, inkjet printing, other digital printing methods, slot die coating, spray coating, dip coating, doctor blade / knife coating, curtain coating, film transfer coating, aerosol jetting. Preference is given to screen printing for an optimal trade-off between appearance and the lowest performance loss and spray coating for an optimal appearance at slightly higher power loss.

Dry layer thickness is in the range of 0.1μm - 200μm, preferably 1μm - 50μm, especially 1μm - 10μm.

The concentration of effect pigments in a dry film is about 1 - 20%, preferably 2 - 10%, especially 5 - 7% based on the total weight of the film.

The coating medium comprising effect pigments according to the invention can be applied to any desired solar cell like amorphous, mono- and multicrystalline silicon solar cells, CIGS, CdTe, III/V solar cells, II/VI solar cells, Perovskite solar cells, organic solar cells and dye sensitized solar cells as well as modules made out of single cells. Crystalline solar cells include cellstructures like Al-BSF, PERC, PERL, PERT, HIT, IBC, bifacial or any other cell type based on crystalline silicon substrates.

The effect pigments can be applied on the exterior of a finished solar cell or module, on the protective substrate covering the module (glass or plastic), on or in any lamination material like EVA, TPU or silicone or directly on the photoactive material/solar cells. Preference is given to application printing on EVA or printing on finished solar cells.

A further possibility of application to solar cells or modular units is the use of a (self-bonding) foil comprising the effect pigments, which may be affixed on glass and other surfaces. This can also be applied to any existing installations of solar modules or solar mini modules or even single cells in hand-hold devices, transportation vehicles, buildings or similar.

It is particularly advantageous of the invention that it is now possible to seamlessly integrate solar cells into buildings (façade and roof), portable and installed devices, automotive vehicles (cars, motorcycles, scooters, trucks and similar) or other kinds of solar installations where the typical technical look of solar cells would make a change to the typical appearance people are used to. Additionally, this improvement is achieved without significant loss in efficiency.

The present invention could also lead to improved long-term stability of solar cells as the pigments can partly block or at least prevent water vapor from passing through flexible plastic foils thus acting as an oxygen and water vapor barrier. Many solar cells made out of II/VI or III/V materials as well as organic ones highly suffer from moisture reaching the surface of the solar cell and causing photooxidation of the active materials.

## EXAMPLES

### EXAMPLE 1:

c-Si solar cells (CZ) are coated with different layers comprising different effect pigments, different pigment concentrations and/or pigment mixtures. The layers comprising effect pigments render the surface appearance of sheets of encapsulated materials to different colors, as e. g. green or violet.

Ink containing Pyrisma® Green (3%) in Proell Aqua Jet FGL M 093 varnish (95,5%) and Proell Defoamer L36459 (1,5%) is printed on a standard c-Si panels using manual flat-bed screen printer. Mesh PET1500 54/137-64W from Sefar is used (parameters of the mesh: 137 I/inch, 115μm mesh opening and 64μm thread diameter). Squeegee used for printing is a manual squeegee with hardness of 75° shore. The layer is dried at room temperature in ambient conditions.

Pigments and pigment concentrations are listed in Table 1.

**Table 1**

| Example | Pigment | Pigment Concentration |
|---|---|---|
|  |  |  |
| 1 | Colorstream® Viola Fantasy | 12% |
| 2 | Pyrisma® Green | 12% |
| 3 | Colorstream® Tropic Sunrise | 12% |
| 4 | Miraval® (formerly Colorstream®) Pacific Twinkle | 3% |
| 5 | Pyrisma® Green | 6% |
| 6 | Miraval® 5402 Pacific Twinkle | 6% |
| 7 | Miraval® 5426 Magic Green | 3% |
| 8 | Miraval® 5426 Magic Green | 6% |
| 9 | Iriodin® 231 Rutile Fine Green | 3% |
| 10 | Iriodin® 231 Rutile Fine Green | 6% |

(continued)

| Example | Pigment | Pigment Concentration |
|---|---|---|
| 11 | Iriodin® 231 Rutile Fine Green | 9% |
| 12 | Iriodin® 299 Flash Green | 3% |
| 13 | Iriodin® 299 Flash Green | 6% |
| 14 | Iriodin® 299 Flash Green | 9% |
| 15 | Xirallic® T60-24 Stellar Green | 6% |
| 16 | Xirallic® T60-24 Stellar Green | 9% |
| 17 | Xirallic® T60-24 Stellar Green | 12% |
| 18 | Pyrisma® T30-24 Green | 3% |
| 19 | Colorstream® T10-01 Viola Fantasy | 3% |
| 20 | Colorstream® T10-01 Viola Fantasy | 6% |
| 21 | Colorstream® T10-01 Viola Fantasy | 9% |
| 22 | $H_2O$-Lack "Pröll FGL M093" | no pigment |
| 23 | UV-Lack "Schmid Rhyner Wessco 34.238.30" | no pigment |
| 24 | Pyrisma® Green Mirror (HM 43-16) | 6% |

Impacts of pigment layers onto c-Si solar cells are assessed by reflection measurements.

Reflection data are used to estimate max. power absorption / max. photo current generation of treated cells:

Spectral reflectance is recorded in wavelength interval between 280 nm to 1200 nm.

Transmission of cells artificially set to zero

Regularly full absorption of short wavelength light by cell's bulk

Calculation of absorption of light by whole system

Absorption in pigment layers, SiNx and Al neglected (since unknown)

Transposition of power absorption to max. achievable photo current based on AM1.5G spectrum

Reflectance standard (PTFE)

Cary 5000 (UV/ViS/NIR); Agilent

All cells (where applicable) are probed 4-time

Cells are subjected to reflectivity measurement

Measurement setup is checked by using 'reference sample'

- Polished Si wafer (p-type) used as reference
- Reference measurement compared with reference measurements from last measurement campaign

Light incidence perpendicular to surface of cells

- No angular dependency of cell's reflectivity data

Reflectivity is measured from front side of cells

- Front side: colored, opposite to full Al electrode
- Measurements are performed with three repetitions (4 measurements in total)
- All reflectivity curves are smoothed post measurement applying Savitzky-Golay-Smoothing
- 2nd order polynomic function
- 25 data points to left and right used as support regime for smoothening process

Irradiated surface is amounted to cover large area fractions up to 1 cm in diameter.

Thus, reflectance data are averaged integrals comprising metallized/non-metallized surface.

Measured data are averaged and averages are used for further considerations:

Averaged mean reflectance of the cell
Estimation of standard deviation & variance
Estimation of T-error range according to probability of 99 % (confidence interval)

"Reference samples" (e. g. pol. Wafer) are probed in two different manners:

Five repetitive measurements of one sample spot
Four different spots (in this case single determinations) as in case of pigment wafers
All measurements carried out using PTFE-standard as reference
Sample beam not covered sealed by light absorbing lid during measurement

Results are summarised in Table 2.

**Table 2**

|  | max. Power Absorbed [W/m$^2$] | rel. Power Loss [%] | max. Photo Current Possible [A/m$^2$] | rel. Current Loss [%] |
|---|---|---|---|---|
| AM1.5G | 836.0 | 0.00 | 464.4 | 0.00 |
| Reference | 769.9 | 0.00 | 427.7 | 0.00 |
| Cell 01 (violet) | 650.0 | -15.57 | 370.0 | -13.49 |
| Cell 02 (green) | 656.5 | -14.73 | 364.4 | -14.80 |
| Cell 03 (green) | 524.2 | -31.91 | 285.7 | -33.20 |
| Cell 04 | 739.5 | -3.96 | 408.4 | -4.51 |
| Cell 05 | 698.7 | -9.25 | 387.2 | -9.46 |
| Cell 6 | 702.0 | -8.83 | 387.4 | -9.43 |
| Cell 7 | 752.0 | -2.33 | 416.1 | -2.71 |
| Cell 8 | 738.3 | -4.11 | 408.7 | -4.44 |
| Cell 9 | 724.2 | -5.93 | 401.1 | -6.22 |
| Cell 10 | 684.7 | -11.07 | 379.8 | -11.19 |
| Cell 11 | 651.6 | -15.37 | 361.7 | -15.42 |
| Cell 12 | 743.2 | -3.47 | 411.5 | -3.80 |
| Cell 13 | 715.9 | -7.01 | 397.2 | -7.13 |
| Cell 14 | 693.0 | -9.99 | 384.9 | -10.01 |
| Cell 15 | 706.9 | -8.18 | 392.9 | -8.14 |
| Cell 16 | 681.3 | -11.51 | 379.1 | -11.35 |
| Cell 17 | 654.5 | -15.00 | 364.5 | -14.77 |
| Cell 18 | 733.4 | -4.75 | 406.0 | -5.08 |
| Cell 19 | 727.8 | -5.47 | 407.2 | -4.80 |
| Cell 20 | 691.3 | -10.21 | 390.0 | -8.82 |
| Cell 21 | 661.2 | -14.12 | 375.6 | -12.18 |
| Cell 22 | 774.4 | 0.59 | 428.2 | 0.11 |
| Cell 23 | 777.7 | 1.02 | 429.8 | 0.49 |

(continued)

| | max. Power Absorbed [W/m$^2$] | rel. Power Loss [%] | max. Photo Current Possible [A/m$^2$] | rel. Current Loss [%] |
|---|---|---|---|---|
| Cell 24 | 702.5 | -8.76 | 389.6 | -8.91 |

**Example 2:**

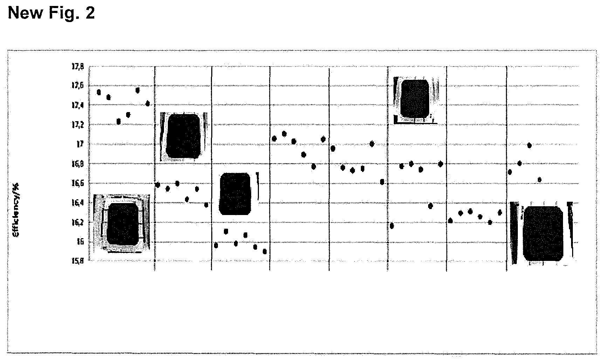

Solar mini modules are prepared in a way that layers containing effect pigments in a water based resin are directly printed on commercially available Al-BSF solar cells. The modules are afterwards contacted by manual melding and encapsulated between a glass plate and a tedlar backsheet using either thermoplastic polyurethane (TPU) or ethyl-vinyl acetate (EVA). The efficiency is measured in standardized setup under AM1.5 conditions and shown in Fig. 2.

While the uncoated reference module shows an efficiency of up to 17.6% none of the tested solar mini modules shows a drop in efficiency exceeding 10% (rel.). Even a white appearing module shows an effective efficiency of 16% due to the selective reflection of light caused by effect pigments.

**Claims**

1.  Solar cell comprising at least one effect pigment consisting of a transparent or semi-transparent flake-form substrate coated with one or more layers of transparent or semi-transparent materials.

2.  Solar cell according to claim 1, where the effect pigment is selected from pearlescent pigments, interference pigments and multi-layer pigments.

3.  Solar Cell according to one or more of claims 1 to 2, where the amount of effect pigment is in the range of 1 - 25%, preferably 1-15 % by weight based on the applied fixation medium like varnish or foil.

4.  Solar cell according to one or more claims 1 to 3, where the effect pigment (layer) has a reflection level of 5-40% preferably < 5% in the area of 260 to 1200 nm wavelength.

5.  Solar cell according to one or more claims 1 to 4, where the effect pigment (layer) has an internal quantum efficiency of > 0,8% in the area of 260 to 1200 nm wavelength.

6.  Solar cell according to one or more claims 1 to 5, where the effect pigment (layer) creates a relative current loss [A/m2] of less than 30 %, preferably less than 15%, most preferably less than 10%.

7.  Solar cell according to one or more claims 1 to 6, where the effect pigment (layer) has an efficiency reduction [W/m2] of less than 30 %, preferable less than 15%, most preferably less than 10%.

8.  Solar cell according to one or more claims 1 to 7, where the effect pigment (layer) has an external quantum efficiency of > 0,8% in the area of 260 to 1200 nm wavelength.

9.  Solar cell according to one or more of claims 1 to 8, where the effect pigment is based on a flake-form glass substrate or a flake-form $SiO_2$ substrate.

10. Solar cell according to one or more of claims 1 to 9, where the flake-form substrate is coated with one or more layers of metal oxides and/or metal oxide hydrates of Ti, Sn, Si, Al, Zr and Zn.

11. Solar cell according to one or more of claims 1 to 10, where the effect pigment is a green effect pigment.

12. Solar cell according to one or more of claims 1 to 11, where the effect pigment is comprised in a layer on the exterior of the solar cell, on or in any lamination material like EVA, TPU or silicone, directly on the photoactive material of the solar cell or on the protective substrate covering a solar cell module.

13. Process for the preparation of solar cells according to claims 1 to 12 where a coating composition comprising an effect pigment comprising a transparent or semi-transparent flake-form substrate coated with one or more layers of transparent or semi-transparent materials, a binder, and optionally an additive is applied to the solar cell.

**14.** Process according to claim 13, where the coating composition is applied by screen printing, flexo printing, gravure printing, offset printing, inkjet printing, other digital printing methods, slot die coating, spray coating, dip coating, doctor blade / knife coating, curtain coating, film transfer coating or aerosol jetting.

**New Fig. 1**

New Fig. 2

Europäisches
Patentamt
European
Patent Office
Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2007/050756 A2 (DU PONT [US]; SMILLIE BENJAMIN ANDREW [CA]; LENGES GERALDINE M [US]) 3 May 2007 (2007-05-03)<br>* abstract *; claims 1-10 *<br>* page 13 * | 1-14 | INV.<br>H01L31/048<br>H01L31/0216 |
| X | WO 2009/143407 A2 (DU PONT [US]; HAYES RICHARD ALLEN [US]; SMITH REBECCA L [US]) 26 November 2009 (2009-11-26)<br>* abstract *; claims 1-20; figures 1-4 *<br>* page 3, line 20 - page 22, last line * | 1-14 | |
| X | EP 2 292 560 A1 (OSAKA GAS CO LTD [JP]) 9 March 2011 (2011-03-09)<br>* abstract *; claims 1-24; figures 1-10 * | 1-14 | |
| X | WO 2012/021460 A2 (YOUNG MICHAEL EUGENE [US]; SRINIVAS ARJUN DANIEL [US]; ROBINSON MATTHE) 16 February 2012 (2012-02-16)<br>* abstract *; claims 1-44; figures 1-12 *<br>* paragraph [0073] - paragraph [0080] * | 1-14 | |
| X | US 2011/023943 A1 (PREJEAN GEORGE WYATT [US]) 3 February 2011 (2011-02-03)<br>* abstract *; claims 1-28; figures 1-3 *<br>* paragraph [0058] * | 1-14 | TECHNICAL FIELDS SEARCHED (IPC)<br><br>H01L |
| X | KR 2011 0022684 A (OSAKA GAS CO LTD [JP]) 7 March 2011 (2011-03-07)<br>* abstract *; claims 1-24; figures 1-10 * | 1-14 | |

The present search report has been drawn up for all claims

| Place of search | Date of completion of the search | Examiner |
|---|---|---|
| Berlin | 12 October 2018 | Hamdani, Fayçal |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 17 21 0122

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2018

| Patent document cited in search report | | Publication date | Patent family member(s) | | Publication date |
|---|---|---|---|---|---|
| WO 2007050756 | A2 | 03-05-2007 | US | 2006057392 A1 | 16-03-2006 |
| | | | WO | 2007050756 A2 | 03-05-2007 |
| WO 2009143407 | A2 | 26-11-2009 | CN | 102037570 A | 27-04-2011 |
| | | | EP | 2286464 A2 | 23-02-2011 |
| | | | JP | 2011521478 A | 21-07-2011 |
| | | | KR | 20110030475 A | 23-03-2011 |
| | | | US | 2009288701 A1 | 26-11-2009 |
| | | | WO | 2009143407 A2 | 26-11-2009 |
| EP 2292560 | A1 | 09-03-2011 | CN | 102066260 A | 18-05-2011 |
| | | | EP | 2292560 A1 | 09-03-2011 |
| | | | KR | 20110022684 A | 07-03-2011 |
| | | | US | 2011079276 A1 | 07-04-2011 |
| | | | WO | 2009154274 A1 | 23-12-2009 |
| WO 2012021460 | A2 | 16-02-2012 | AU | 2011289620 A1 | 21-03-2013 |
| | | | CA | 2829242 A1 | 16-02-2012 |
| | | | CN | 103155174 A | 12-06-2013 |
| | | | EP | 2601688 A2 | 12-06-2013 |
| | | | JP | 5988974 B2 | 07-09-2016 |
| | | | JP | 2013535843 A | 12-09-2013 |
| | | | KR | 20130129912 A | 29-11-2013 |
| | | | US | 2012132930 A1 | 31-05-2012 |
| | | | US | 2015014022 A1 | 15-01-2015 |
| | | | US | 2016029482 A1 | 28-01-2016 |
| | | | WO | 2012021460 A2 | 16-02-2012 |
| US 2011023943 | A1 | 03-02-2011 | CN | 102859863 A | 02-01-2013 |
| | | | EP | 2460266 A1 | 06-06-2012 |
| | | | JP | 5650737 B2 | 07-01-2015 |
| | | | JP | 2013501102 A | 10-01-2013 |
| | | | KR | 20120052360 A | 23-05-2012 |
| | | | TW | 201109350 A | 16-03-2011 |
| | | | US | 2011023943 A1 | 03-02-2011 |
| | | | WO | 2011014777 A1 | 03-02-2011 |
| KR 20110022684 | A | 07-03-2011 | CN | 102066260 A | 18-05-2011 |
| | | | EP | 2292560 A1 | 09-03-2011 |
| | | | KR | 20110022684 A | 07-03-2011 |
| | | | US | 2011079276 A1 | 07-04-2011 |
| | | | WO | 2009154274 A1 | 23-12-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5648906 B
- WO 2011095326 A1
- DE 2215191
- DE 3151354 A
- DE 3235017 A
- DE 3334598 A
- EP 0090259 A
- EP 0634459 A
- WO 9957204 A
- WO 9632446 A
- US 5759255 A
- US 5571851 A
- WO 0192425 A
- WO 2011095326 A